Europäisches Patentamt

European Patent Office

Office européen des brevets

(19)

(11) Publication number: **0 429 720 A1**

## EUROPEAN PATENT APPLICATION

(21) Application number: 89203052.9

(22) Date of filing: 01.12.89

(51) Int. Cl.⁵: **G11C 16/04, G11C 16/06**

(43) Date of publication of application:
05.06.91 Bulletin 91/23

(84) Designated Contracting States:
CH DE FR GB IT LI SE Bulletin 00/2

(71) Applicant: **N.V. Philips' Gloeilampenfabrieken**
**Groenewoudseweg 1**
**NL-5621 BA Eindhoven(NL)**

(72) Inventor: **Vollebregt, Franciscus Hendricus**
**Albertus**
**c/o INT. OCTROOIBUREAU B.V. Prof.**
**Holstlaan 6**
**NL-5656 AA Eindhoven(NL)**
Inventor: **Cuppens, Roger**
**c/o INT. OCTROOIBUREAU B.V. Prof.**
**Holstlaan 6**
**NL-5656 AA Eindhoven(NL)**

(74) Representative: **Strijland, Wilfred et al**
**INTERNATIONAAL OCTROOIBUREAU B.V.**
**Prof. Holstlaan 6**
**NL-5656 AA Eindhoven(NL)**

(54) Single-transistor-EEPROM-cell.

(57) An EEPROM, for instance a flash-EEPROM, is disclosed wherein the write-voltages and the erase-voltages to be applied have been interchanged in comparison with prior art memories.

Consequently, the developing of normally-on memory-cell-transistors due to over-charging is prevented in the erase mode. In the write mode the over-charging-problem can be dealt with elegantly. Higher densities can be achieved and, as the operation is based on the tunneling in the write mode as well as in the erase mode, an on-chip high voltage generation will suffice.

FIG.2

## SINGLE-TRANSISTOR-EEPROM-CELL.

The invention relates to a integrated circuit comprising an electrically erasable programmable read only memory, including a memory cell that comprises a floating-gate-structure and including control means for in a write mode writing the cell by means of inducing a tunneling of charge carriers towards or from the floating gate and for in an erase mode erasing the cell by means of inducing a tunneling of the charge carriers from or towards the floating gate, and to a method for writing a memory cell with a floating-gate structure by means of inducing a tunneling of charge carriers towards or from the floating gate and for erasing the memory cell by means of inducing a tunneling of the charge carrier from or towards the floating gate.

In the field of integrated memory circuits in general, major efforts are aimed at boosting densities and speeds, and at reducing power consumption. Within the field of nonvolatile memories in particular, the electrically programmable read only memories (EPROMs) are on a fast track towards higher densities, due to the development of single-transitor memory cells and also because of the EPROMs' easy scaling. For another kind of nonvolatile memory, the erasable EPROM (EEPROM) one of the techniques for achieving EPROM-like densities involves merging the hot-electron avalanche-injection programming mechanism of EPROMs with the cold-electron Fowler-Nordheim tunneling erase mechanism, achieving what is known as the flash-EEPROM (FEE), that comprises single-floating-gate-transistor cells. Usually in a FEE the contents of all the array's memory cells are erasable simultaneously by a single field emission of electrons from the floating gates. These electrically bulk erasable PROMs offer an attractive trade-off between expensive EEPROMs and relatively inexpensive EPROMs.

In order to obtain a sufficient amount of hot-electrons, required in the program mode of a conventional FEE externally generated relatively high supply voltages are needed in addition to the low supply voltages for the read mode. Due to the hot-electron mechanism the power consumption is relatively large.

Recently, a low current FEE has been disclosed in: "A 5-Volt Contactless Array 256 Kbit Flash EEPROM Technology", M. Gill et al., IEDM 88 (1988), pages 428-431, that does not need an external dual power supply and that, as a consequence, enables in-circuit alterability with existing system supplies. This known memory employs cells each whereof comprises a floating gate structure merged with a series enhancement pass gate.

Both the programming mechanism and the erasing mechanism utilizes the Fowler-Nordheim tunneling to move the electrons from the floating gate to the cell's source junction and vice versa, respectively. The tunneling as an operating mechanism results in a relatively low power consumption. This allows for on-chip generation of program- and erasing voltages while needing only an external low voltage supply, e.g. 5 Volts.

The pass gate merely serves as a control means for preventing the cell from drawing current due to over-erasing the floating gate structure into depletion, that is into a normally-on state.

Although this architecture requires, strictly speaking, two transistors per cell (split-gate), the overall cell substrate area is kept small owing to the use of buried source-regions and drain-regions of the cells, said regions consituting buried bitlines. As a consequence thereof an additional advantage is obtained in the form of a reduction of parasitic capacitances.

However, the need for a pass gate in the prior art memory cell forms a lower bound as regards the required substrate area per stored bit. It is therefore an object of the invention to provide an EEPROM that effects higher densities than the prior art memories by avoiding the presence of pass gates in the memory cells.

To this end a memory according to the invention is characterized in that the memory cell comprises only a single transistor, the control means controlling in the erase mode the tunneling of the charge carriers in such a way as to raise an absolute value of said transistor's threshold voltage. For instance, in a N-channel transistor device, the tunneling of electrons during erasing is directed towards the floating gate thus preventing an inversion layer from developing. A possible over-erasure only will contribute to a still higher threshold value of the transistor. So according to the invention, no normally-on transistors will be obtained due to an over-erasure of the memory cell. In fact, the write-operation and the erase-operation conducted on the memory cell have been interchanged as compared with prior art circuitry. The problem related to a possibly excessive amount of charge at the floating gate now is shifted towards the write mode. However, ways of preventing disadvantageous effects from occurring are possible in the write mode more elegantly than in the erase mode of the prior art circuit as will be set forth hereinbelow.

An additional advantage of this interchanging of the write mode and erase mode as compared with the prior art relates to the dimensions of the floating gate structure. On behalf of a short write cycle in a prior art memory, that is, on behalf of a fast increase of the amount of charge carriers by means of tunneling toward the floating gate, either a rather large coupling area between the floating gate and an externally accessable control gate of the floating-gate-structure, or a high control voltage at the control gate, or both, are required. Interchanging the write function and the erase function according to the invention avoids this requirement, while allowing for a smaller coupling area and therefor for still smaller memory cells. The reduction of the high control voltage at the control gate is of particular importance for embedded FEEs.

As has already been announced hereinabove, a solution to the problem of disadvantageous consequences of an excessive amount of charge carriers trapped at the floating gate, is to control the voltages at a drain region and at a source region of the cell-transistor in such a way that the developing of a conduction channel between these regions is enabled during the writing of the cell. In a N-channel device, for instance, the source region is to be grounded while draining the electrons off the floating gate by means of a high voltage at the drain. This draining will go on until a sufficient level of positive charge will appear at the floating gate for inducing an inversion layer (channel) in the substrate. Thereupon conduction in the channel will cause a decreasing of the drain voltage while terminating the writing. This decreasing of the drain voltage may function as a signal for the memory control means for terminating the write-cycle. A detector for detecting this decreasing may be provided in the contol means.

Another solution to the above problem to drain the charges present at the floating gate in a controlled step-wise manner, thus enabling an accurate charge-transport.

To this end, the control means may include a pulse-generator for in the write-mode stepwise lowering the absolute value of the threshold voltage, related to the amount of charge left at the floating gate. Between two of such steps a verification cycle may be execute for verifying whether or not a sufficient amount of charge has been removed.

It should be noted that in conventional flash EEPROMs this verification and stepwise draining is to be executed in the erase mode for all memory cells, whereas in an EEPROM according to the invention these operations only relate to the cells that are selected for writing.

Preferably, the source region and the drain region of each memory-cell-transistor are buried underneath a thick oxide. A plurality of memory cell transistors may at least have a common buried source region or a common buried drain region. This architecture allows the use of bitline contacts that are common to several memory cells.

This buried drain-and-source-architecture has the further advantageous consequences that the cells can be compact and that the stray capacitances are substantially reduced. The prior art memory uses buried source and drain regions as well.

Preferably, the memory is realized as a flash-EEPROM. High densities in combination with low power consumption and therefore with an on-chip operation voltage generation circuit can be achieved. Such an EEPROM is suitable for being integrated with a microprocessor or a microcontroller as well as for a stand-alone memory.

The above cell structure lends itself in particular to the purpose of realizing EEPROMs with standard technology. Consequently, integrating an EEPROM according to the invention and a microprocessor on the same chip in a standard process can be done perfectly well and cheap.

The invention will be described hereinafter by way of example and with reference to the accompanying diagrammatic drawing, in which:

Figures 1A and 1B show a prior art low current memory cell;

Figure 2 shows an example of a memory cell for use in a memory according to the invention;

Figure 3 shows an example of a part of a lay-out for a memory according tot the invention;

Figures 4A and 4B give tables showing exemplary control voltages for controlling a memory according to the invention.

Throughout the Figures like reference numerals will indicate similar or corresponding features.

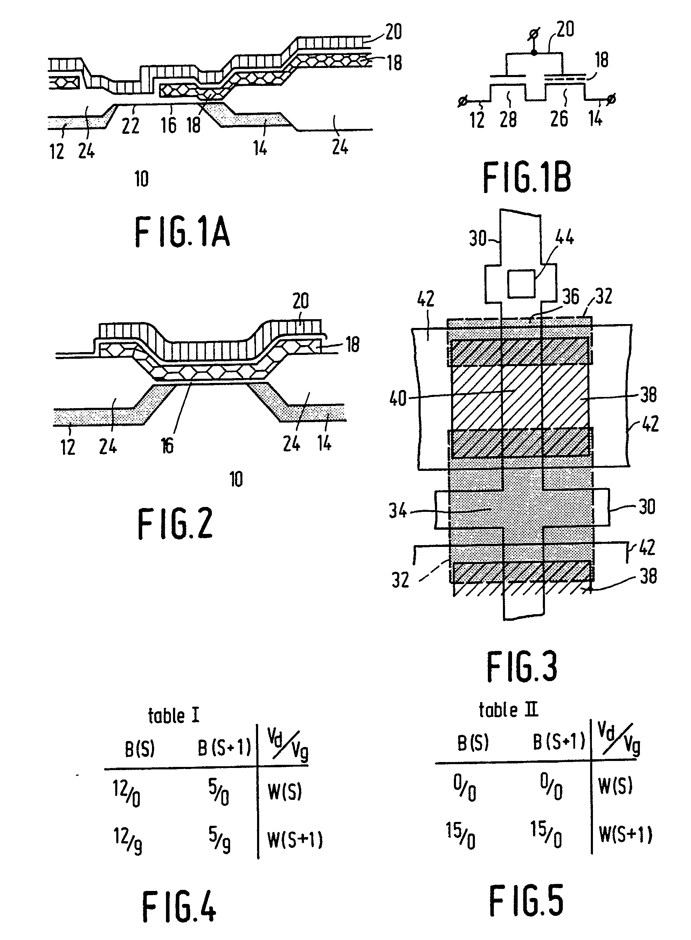

In Figure 1A a cross-section of a prior art low-current cell is shown for use in a flash-EEPROM (FEE), the cell comprising a floating-gate structure. In a $P^-$-type substrate 10 a buried $V^+$-drain-region 12 and a buried $N^+$-source-region 14 define a transistor channel 16, a floating gate 18 partly extending across channel 16 and source-region 14. A control gate 20 is disposed on top of the floating gate 18 and along the part 22 of channel 16 that is not controlled by floating gate 18. Oxide 24 constitutes the dielectric between the floating gate 18 on the one hand and the substrate 10 and control gate 20 on the other hand. The oxide 24 between the floating gate 18 and source-region 14 is about 100 A° thick for enabling the Fowler-Nordheim tunneling. Like in most FEE-designs, the transistor is based on the so-called Flotox-principle (Floating gate thin oxide). Writing into the cell is accomplished by forcing electrons to tunnel through the oxide 24 towards the floating gate 18. Erasing the cell is accomplished by draining the electrons from the floating gate 18 also via the tunneling mechanism. The shown memory cell merges a programmable transistor 26 with a series enhancement pass gate 28 in a so-called split-gate structure (See Figure 1B). This pass-gate 28 that is located at the indicated part 22, prevents the cell from draining current when the floating-gate structure is over-erased into depletion, leaving the programmable transistor 26 in a normally-on state. Thus the cell current is controlled by the pass-gate 28.

In Figure 2 an example of a memory cell for use in a memory according to the invention is shown. The cell now consists of only a single floating-gate transistor, in this example of the N-channel type. As compared with the cell of Figure 1, now the pass-gate has been omitted. In order to prevent the undesirable development of a normally-on device during erasing the invention now interchanges the direction of the tunneling in the program mode and the erase mode as regards the prior art memory cell. Therefore, according to the invention, writing is accomplished by forcing the charge carriers, in this example electrons, to tunnel off the floating-gate 18, while leaving the transistor with a lower threshold voltage. Erasing of the cell according to the invention takes place on the other hand by forcing the electron for tunnel towards the floating gate 18, resulting in a normally-off device, irrespective as to whether the cell develops a neutral floating gate or an over-charged floating gate.

The problem of an over-charging of the floating gate has now shifted from the erase-mode in the prior art memory to the write mode in the memory according to the invention. As has already been stated, several elegant solutions exist to this problem in the write mode. Referring to the above example of Figure 2, a solution is to drain the electrons off the floating gate in a pulse-like function, for instance by alternatingly switching the drain region 14 between a low and a high voltage (15 Volt for instance) under control of a control means (not shown) for accurately determining the amount of electrons to be removed. Another solution is to ground the source region 14 while applying a high voltage (15 Volts for instance) to the drain and a predetermined voltage to the control gate 20 (for instance 1 Volt). When a sufficient amount of electrons has been tunnelled towards the drain region 12 the charge at the floating gate 18 will become of a positive polarity, while inducing an inversion layer in the substrate 10 between the source and the drain regions 14 and 12. The onset of the development of the transistor channel at 16 will result in a decrease of the drain voltage and therefore in the terminating of the writing. The collapse of the drain voltage may function as a control signal for the control means for upon detection thereof terminating the write cycle.

In Figure 3 a part of a lay-out of an exemplary FEE according to the invention is presented .diagrammatically. The OD-mask 30 and the AX-mask 32 together define the location of the active regions (sources 34, drains 36) of the memory cells, which regions are to be buried underneath a thick oxide layer. The floating gate 38 is disposed in such a way as to extend over the active regions (34 and 36) separated therefrom and from channel 40 by a thin tunneling oxide layer (100 A°).

The control gate 42 for external control access is located above the floating gate 38 and is common to a plurality of memory cells (not further shown) arranged on the same row. In the example shown, each memory cells has its own drain contact 44, while its source is shared with several neighbouring cells, here with at least three others (not shown completely). In another example (not shown) a drain contact may be common to a plurality of neighbouring cells.

In Figure 4 a table I represents a schedule for applying control voltages to a memory according to Figures 2 and 3 for writing a selected cell located at bitline B(S) and word-line W(S). Owing to the symmetry inherent to the memory, only the selected cell and three of its nearest neighbours are shown.

The memory cells are of the N-channel type. For writing in cell [B(S); W(S)] a voltage of $V_d$ = 12 Volts has to be applied to its drain while keeping the control-gate voltage $V_g$ low, for instance at 0 Volts. Preventing a neighbouring cell [B(S + 1);W-(S)] at the same wordline W(S) from being written is accomplished by applying to its drain a voltage $V_d$ = 5 Volts. A cell [B(S);W(S + 1)] on the same bitline B(S) is prevented from being written by applying to its control gate a voltage of $V_g$ = 9 Volts. The above determines the voltages to be applied to the cell at [B(S + 1), W(S + 1)], that is $V_d$ = 5 Volts at its drains and $V_g$ = 9 Volts at its control gate, avoiding the occurence of a write operation.

In Figure 5 a table II represents a schedule for applying control voltages to a memory according to Figures 2 and 3 for erasing a row of the memory. Because of the symmetry inherent to the memory only the voltages for four cells are shown, located at bitlines B(S), B(S + 1) and wordlines W(S) and W(S + 1). Erasing a cell is done by applying 15 Volts at its control gate while grounding its drain. It will be clear that for erasing the whole array, all relevant drains should be kept at 15 Volts while the relevant sources should be kept grounded.

## Claims

1. Integrated circuit comprising an electrically erasable programmable read only memory, including a memory cell that comprises a floating-gate-structure and including control means for in a write mode writing the cell by means of inducing a tunneling of charge carriers towards or from the floating gate and for in an erase mode erasing the cell by means of inducing a tunneling of the charge carriers from or towards the floating gate, characterized in that the memory cell comprises only a single transistor, the control means controlling in the erase mode the tunneling of the charge carriers in such a way as to raise an absolute value of said transistor's threshold voltage.

2. Integrated circuit as claimed in Claim 1, characterized in that the control means control in the write mode voltages at a source region and a drain region of said transistor in such a way as to enable a developing of an inversion layer between the source region and the drain region during writing.

3. Integrated circuit as claimed in Claim 2, characterized in that the control means includes a detector for upon detection of a voltage-change at the source region or at the drain region due to said developing of the inversion layer terminating the writing of the cell.

4. Integrated circuit as claimed in Claim 1, characterized in that the control means includes a pulse generator for in the write mode stepwise lowering said absolute value of the threshold voltage in a sequence of tunneling events.

5. Integrated circuit as claimed in Claim 1, characterized in that the single transistor has a buried source region and a buried drain region.

6. Integrated circuit as claimed in Claim 5, the memory including a plurality of memory cells with at least a common buried source region or a common buried drain region.

7. Integrated circuit as claimed in Claim 1, 2, 3, 4, or 5, the memory being of the flash-EEPROM-type.

8. Integrated circuit as claimed in Claim 1, 2, 3, 4, 5 or 6, the memory being integrated with a microprocessor.

9. Method for writing a memory cell with a floating-gate structure by means of inducing a tunneling of charge carriers towards or from the floating gate and for erasing the memory cell by means of inducing a tunneling of the charge carrier from or towards the floating gate, characterized in that, the memory cell comprising only a single transistor, the erasing of the memory cell is performed by controlling the tunneling of the charge carriers in such a way as to raise an absolute value of said transistor's threshold voltage.

10. Method as claimed in Claim 9, characterized in that the writing of the memory cell is performed by controlling voltages at a source region and at a drain region of said transistor in such a way as to enable a developing of an inversion layer between the source region and the drain region during writing.

11. Method as claimed in Claim 9, characterized in that upon detection of a voltage change at the source region or the drain region due to the developing of the inversion layer the writing is terminated.

12. Method as claimed in Claim 9, characterized in that the writing is performed by stepwise lowering said absolute value of the threshold voltage in a sequence of tunneling events under voltage-pulse control.

FIG.1A

FIG.1B

FIG.2

FIG.3

**table I**

| B(S) | B(S+1) | $V_d/V_g$ |
|------|--------|-----------|
| $12/0$ | $5/0$ | W(S) |
| $12/9$ | $5/9$ | W(S+1) |

FIG.4

**table II**

| B(S) | B(S+1) | $V_d/V_g$ |
|------|--------|-----------|
| $0/0$ | $0/0$ | W(S) |
| $15/0$ | $15/0$ | W(S+1) |

FIG.5

PHN 13169

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 255 963 (NEC CORP.)<br>* Column 3, line 49 - column 4, line 58; figures 4,5 * | 1-3,9-11 | G 11 C 16/04<br>G 11 C 16/06 |
| X | EP-A-0 052 566 (FAIRCHILD CAMERA & INSTRUMENTS)<br>* Page 10, line 17 - page 14, line 15; page 20, line 8 - page 21, line 25; page 28, line 21 - page 29, line 14; figures 1,2 * | 1,4,9,11,12 | |
| A | EP-A-0 055 803 (IBM CORP.)<br>* Page 8, line 9 - page 10, line 15; page 11, lines 25-27 * | 1,2 | |
| X | 1988 SYMPOSIUM ON VLSI TECHNOLOGY, DIGEST OF TECHNICAL PAPERS, San Diego, 10th - 13th May 1988, pages 33-34; R. SHIROTA et al.: "A new NAND cell for ultra high densitiy 5V-only EEPROMs"<br>* Page 33; figure 1A * | 1 | |
| A | IDEM | 7 | TECHNICAL FIELDS SEARCHED (Int. Cl.5)<br><br>G 11 C 16/04<br>G 11 C 16/06 |

The present search report has been drawn up for all claims

| Place of search | Date of completion of the search | Examiner |
|---|---|---|
| THE HAGUE | 02-08-1990 | KAMSAETER K.M.S. |

EPO FORM 1503 03.82 (P0401)